# EUROPEAN PATENT APPLICATION

(11) **EP 1 447 440 A1**
(43) Date of publication of application: **18.08.2004**
(21) Application number: 02770236.4
(22) Date of filing: 23.10.2002
(51) Int. Cl.: C11D 7/10, C11D 7/50, H01L 21/304, H01L 21/308

(54) **COMPOSITION FOR CLEANING**

(30) Priority: 24.10.2001 JP 2001326948
(71) Applicant: Daikin Industries, Ltd., Osaka-shi, Osaka 530-8323 (JP)
(72) Inventor: ITANO, M., Yodogawa Seisakusho DAIKIN IND., LTD., Settsu-shi, Osaka 566-0044 (JP); KEZUKA, T., Yodogawa Seisakusho DAIKIN IND., LTD., Settsu-shi, Osaka 566-0044 (JP)
(74) Representative: HOFFMANN - EITLE
(86) International application number: PCT/JP2002/010976
(87) International publication number: WO 2003/035815

(57) **Abstract**

A cleaning composition comprising (1) at least one fluoride and/or hydrogendifluoride salt formed from at least one member selected from the group consisting of hydroxylamines, aliphatic amines, aromatic amines, aliphatic quaternary ammonium salts and aromatic quaternary ammonium salts with hydrofluoric acid; (2) at least one organic solvent that includes one or more heteroatoms; and (3) water.

## Description

### TECHNICAL FIELD

The present invention relates to a cleaning composition that can be used in the process of fabricating semiconductors. Specifically, the invention relates to a cleaning composition that does not cause surface roughness when cleaning STIs, metal gates, contact holes, via holes, capacitors, etc.; removing polymers attributable to resist and post-CMP cleaning. The composition is suitably used during the fabrication of liquid crystal panels and IC, LSI and like semiconductor elements.

### BACKGROUND ART

Heretofore, poly-Si has been used as a material for gate electrodes; however, with the miniaturization of semiconductor elements, there is a possibility that tungsten, copper, aluminum and like metals will be used as a material for gate electrodes. However, SPM (H₂SO₄-H₂O₂-H₂O), APM (NH₄OH-H₂O₂-H₂O), HPM (HCl-H₂O₂-H₂O), DHF (HF-H₂O), etc., which are used as compositions for cleaning gates, contact holes and capacitors, tend to corrode metals. Therefore, there is a demand for a cleaning composition that can remove polymers attributable to resist or the like and native-oxide films, etc., and that has little tendency to corrode metals.

Liquid crystal panels and ICs, LSIs and like semiconductor elements are fabricated by uniformly depositing photo resist onto a conductive metal film formed of aluminum, copper, aluminum-copper alloy, etc., or onto an insulating film formed of SiO₂, etc., that is formed on a substrate; forming a resist pattern by lithography; selectively etching the conductive metal film or insulating film; and removing the remaining resist by ashing, a polymer-removing composition, etc.

Examples of known compositions for removing polymers include those such as disclosed in Japanese Unexamined Patent Publication Nos. 1997-197681 and 2000-47401, in which DMF, DMSO and like water-soluble organic solvents are added into an aqueous solution of a fluoride salt and to which, if necessary, hydrofluoric acid is further added. However, it is difficult to have both low corrosiveness to metals and high degree of polymer removability, and the heretofore used compositions for removing polymers have room for improvement in the balance of these properties.

When the structure of an IC is complicated and multi-level interconnectivity is advanced, single or dual damascene processes are employed to form interconnections. In these processes, chemical mechanical polishing (CMP) is performed using a polishing agent, and therefore a great many particles attributable to the polishing agent adhere to the processed surface being subjected to the damascene process, or the particles are embedded in the film surface during the polishing process. After conducting general CMP of an oxide film, brush cleaning using DHF (HF-H₂O), APM (NH₄OH-H₂O₂-H₂O) or the like cleaning compositions is performed. However, because metal (Al, Al-Cu, Cu, TiN, etc.) exists on the surface to be cleaned after the damascene process, when such cleaning compositions are used, the surface of the metal is easily corroded, and therefore it is disadvantageous to use such cleaning compositions.

WO 00/31786 discloses an etching solution that etches a doped oxide film and thermal oxide film at the same rate. Specifically, the publication discloses etching of a doped oxide film and a thermal oxide film using an etching solution comprising (i) ammonium fluoride or ammonium hydrogendifluoride, (ii) water and (iii) isopropyl alcohol (IPA) and like heteroatom-containing organic solvents. When a thermal oxide film is etched using an etching solution disclosed in WO 00/31786 that contains NH₄F or NH₄F · HF/water/IPA, surface roughness occurs on the etched oxide film.

An object of the present invention is to provide a composition for cleaning STIs, metal gates, contact holes, via holes, capacitors, etc., wherein the composition has little corrosiveness to metals (for example, Al, Al-Cu, Cu, W, WN, Ti, TiN), little damages to silicon oxide films, has appropriate properties to clean polymer and native-oxide films, and does not roughen the cleaned surface.

### DISCLOSURE OF THE INVENTION

The invention provides a cleaning composition comprising: (1) at least one fluoride and/or hydrogendifluoride salt formed from at least one member selected from the group consisting of hydroxylamines, aliphatic amines, aromatic amines, aliphatic quaternary ammonium salts and aromatic quaternary ammonium salts with hydrofluoric acid; (2) at least one organic solvent that includes one or more heteroatoms; and (3) water.

The invention provides a method for removing a deposited substance from an object to be cleaned that has at least one STI, metal gate, contact hole, via hole or capacitor, comprising the step of cleaning the object using the above-described composition.

The composition of the invention comprises (1) at least one fluoride and/or hydrogendifluoride salt formed from at least one member selected from the group consisting of hydroxylamines, aliphatic amines, aromatic amines, aliphatic quaternary ammonium salts and aromatic quaternary ammonium salts with hydrofluoric acid; (2) at least one organic solvent including one or more heteroatoms; and (3) water, and is usable for cleaning STIs, metal gates, contact holes, via holes, capacitors, etc., during the process for fabricating a semiconductor. The cleaning composition can also be used for removing polymer left on side walls of STIs, contact holes, capacitors, metal gates, via holes, metal wiring, etc.; removing resist residues after ion implantation; removing attached polymer after dry etching in a single damascene or dual damascene process; and post-CMP cleaning in single damascene or dual damascene processes.

The at least one member selected from the group consisting of hydroxylamines, aliphatic amines, aromatic amines, aliphatic quaternary ammonium salts and aromatic quaternary ammonium salts that is contained in the cleaning composition of the invention can form a salt with hydrofluoric acid.

Examples of such hydroxylamines include hydroxylamines mono- or di-substituted with a phenyl group or a straight or branched alkyl group having 1-4 carbon atoms, such as N,N-dimethylhydroxylamine, N-ethylhydroxylamine, N,N-diethylhydroxylamine, N-propylhydroxylamine, N-phenylhydroxylamine and the like.

Examples of such aliphatic amines include aliphatic amines mono-, di- or tri-substituted with a straight or branched alkyl group having 1 to 8 carbon atoms such as ethylamine, propylamine, isopropylamine, butylamine, hexylamine, octylamine, decylamine, dodecylamine, dimethylamine, diethylamine, dipropylamine, diisopropylamine, dibutylamine, trimethylamine, triethylamine, tripropylamine, triisopropylamine, tributylamine and the like; aliphatic amines mono-, di- or tri-substituted with a straight or branched C₁-C₈ alkyl group having at least one fluorine atom such as monofluoromethylamine, difluoromethylamine, trifluoromethylamine, perfluoroethylamine, perfluoropropylamine, perfluoroisopropylamine, perfluorobutylamine, perfluorohexylamine, perfluorooctylamine, di(perfluoromethyl)amine, di(perfluoroethyl)amine, di(perfluoropropyl)amine, di(perfluoroisopropyl)amine, di(perfluorobutyl)amine, tri(perfluoromethyl)amine, tri(perfluoroethyl)amine, tri(perfluoropropyl)amine, tri(perfluoroisopropyl)amine, tri(perfluorobutyl)amine and the like; ethanolamine, ethylenediamine, 2-(2-aminoethylamino)ethanol, diethanolamine, 2-ethylaminoethanol, dimethylaminoethanol, ethyldiethanolamine, cyclohexylamine, dicyclohexylamine, etc.

Examples of aromatic amines include aniline, N-methylaniline, N,N-dimethylaniline, benzylamine, dibenzylamine, N-methylbenzylamine, etc.

Examples of aliphatic or aromatic quaternary ammonium salts include chlorides, bromides, sulfates, nitrates and like mineral acid salts of tetraethylammonium, tetrapropylammonium, tetraisopropylammonium, tetrabutylammonium, tetraphenylammonium and like aliphatic or aromatic quaternary ammoniums.

The preferable fluoride of the invention is expressed by the general formula below:

N(R¹) (R²)₃ · F

wherein R¹ represents a straight or branched C₁₋₁₂ alkyl group that is optionally substituted with one or more fluorine atoms and/or hydroxyl groups, a phenyl group that is optionally substituted with one or more fluorine atoms, or hydroxyl group. Each R² may be the same or different and independently represents a straight or branched C₁₋₁₂ alkyl group that is optionally substituted with one or more fluorine atoms and/or hydroxyl groups, a phenyl group that is optionally substituted with one or more fluorine atoms, or a hydrogen atom.

The preferable hydrogendifluoride of the invention is expressed by the general formula below:

N(R¹) (R²)₃ · HF₂

wherein R¹ and R² are as defined above.

As for the hydrogen difluorides contained in the composition of the invention, crystals or an aqueous solution of the hydrogen difluoride may be used or the theoretical amount of the fluoride and HF may be combined to form the hydrogen difluoride within the composition.

Examples of organic solvents including one or more heteroatoms contained in the composition of the invention include *N,N*-dimethylformamide, *N,N*-dimethylacetamide, dimethysulfoxide, *N*-methyl-2-pyrrolidone, 1,3-dimethyl-2-imidazolidinone; methanol, ethanol, isopropyl alcohol (IPA), 1-propanol, 1-butanol, 2-butanol, *t*-butanol, 2-methyl-1-propanol, 1-pentanol, 1-hexanol, 1-heptanol, 4-heptanol, 1-octanol, 1-nonyl alcohol, 1-decanol, 1-dodecanol and like alcohols; ethylene glycol, 1,2-propanediol, propylene glycol, 2,3-butanediol, glycerol and like polyols; acetone, acetylacetone, methyl ethyl ketone, 1,3-dihydroxyacetone and like ketones; acetonitrile, propionitrile, butyronitrile, isobutyronitrile, benzonitrile and like nitriles; formaldehyde, acetaldehyde, propionaldehyde and like aldehydes; ethylene glycol monomethyl ether, ethylene glycol monoethyl ether, diethylene glycol monobutyl ether and like alkylene glycol monoalkyl ethers; tetrahydrofuran, dioxane and like cyclic ethers; trifluoroethanol, pentafluoropropanol, 2,2,3,3-tetrafluoropropanol and like fluorinated alcohols; sulfolane and nitromethane. Oxygen-containing organic solvents such as alcohols and ketones are especially preferable. Specifically, methanol, ethanol, n-propanol, isopropanol (IPA) and like alcohols; and acetone, methyl ethyl ketone, 1,3-dihydroxyacetone and like ketones are most preferable. These heteroatom-containing organic solvents may be used alone or in a combination of two or more members.

When the oxygen-containing organic solvent used in the composition of the invention is at least one member selected from the group consisting of isopropyl alcohol, ethanol and methanol, it is preferable that the concentration of water be 10 mass% or less.

When an alcohol is used as a solvent, the composition of the invention generally contains (1) 0.001-10 mass% of at least one member selected from fluorides and hydrogendifluorides, (2) 80-99.989 mass% of alcohols and (3) 0.01-10 mass% of water; and preferably (1) 0.005-5 mass% of at least one member selected from fluorides and hydrogendifluorides, (2) 85-99.985 mass% of alcohols and (3) 0.01-10 mass% of water.

More specifically, it is preferable that (1) the concentration of the fluoride expressed by the general formula below be 10 mass% or less:

N(R¹) (R²)₃ · F

wherein R¹ represents a straight or branched C₁₋₁₂ alkyl group that is optionally substituted with one or more fluorine atoms and/or hydroxyl groups, a phenyl group that is optionally substituted with one or more fluorine atoms, or hydroxyl group, and R² may be the same or different and each independently represents a straight or branched C₁₋₁₂ alkyl group that is optionally substituted with one or more fluorine atoms and/or hydroxyl groups, a phenyl group that is optionally substituted with one or more fluorine atoms, or a hydrogen atom; and/or the concentration of the hydrogendifluoride expressed by the general formula below be 10 mass% or less:

N(R¹) (R²)₃ · HF₂

wherein R¹ and R² are as defined above; (3) the concentration of water be 10 mass% or less; and (2) the balance be at least one member selected from the group consisting of isopropyl alcohol, ethanol and methanol.

The composition of the invention may further contain (4) surfactant. The surfactant may contain one or more members selected from anionic, cationic and nonionic surfactants. Among them, anionic surfactants are preferable.

Preferable anionic surfactants include carboxylic acid-type, sulfonic acid-type and sulfuric ester-type surfactants of whose hydrophilic groups are expressed by the general formulae -COOM, -SO₃M, or -OSO₃M where M is a hydrogen, ammonium or metal atom. Preferable salts include metal salts of alkali metals (for example, sodium and potassium), etc., ammonium salts and primary, secondary or tertiary amine salts. The metals may be monovalent or bivalent. Among these, sulfonic acid-type anionic surfactants are preferable.

Examples of carboxylic acid-type surfactants include CF₃(CF₂)ₐCOOH, (CF₃)₂CF(CF₂)ₐCOOH, HCF₂(CF₂)ₐCOOH, CF₃(CF₂)ₐ(CH₂)_{b}COOH, CF₃(CF₂)ₐCF=CH (CH₂)_{b}COOH, Cl(CF₂CFCl)ₚCF₂COOH wherein a is an integer from 2 to 17, b is an integer from 1 to 2, and p is an integer from 1 to 9, and alkali metal, ammonium, primary amine, secondary amine, and tertiary amine salts of these, etc.

Specific examples thereof include CF₃(CF₂)ₐCOONa, (CF₃)₂CF(CF₂)ₐCOONa, HCF₂(CF₂)ₐCOONa, CF₃(CF₂)ₐ(CH₂)_{b}COONa, CF₃(CF₂)ₐCF=CH(CH₂)_{b}COONa, Cl(CF₂CFCl)ₚCF₂COONa, etc., wherein a and b are as defined above.

Examples of sulfonic acid-type surfactants include C_{c}H_{2c+1}SO₃H, C_{c}H_{2c+1}O(CH₂CH₂O)_{d}SO₃H or C_{c}H_{2c+}1-Ph-SO₃H wherein Ph is a phenylene group, c is an integer from 5 to 20 and d is an integer from 0 to 20; CₙHₘC₆H₃(SO₃H)Oph(SO₃H) wherein Ph is a phenylene group, n is an integer from 1 to 30 and m is an integer from 3 to 61, CₙHₘPh(SO₃H) wherein Ph is a phenylene group, n is an integer from 1 to 30 and m is an integer from 3 to 61; and metal, ammonium, primary amine, secondary amine, and tertiary amine salts of these, etc.

Specific examples thereof include C₁₂H₂₅O(CH₂CH₂O)₂SO₃Na, C₉H₁₉PhO(CH₂CH₂O)₄SO₃Na, C₁₂H₂₅O(CH₂CH₂O)₄SO₃Na, C₆F₁₁PhSO₃Na, C₉F₁₉OPhSO₃Na, R''''CH=CH (CH₂)ⱼSO₃Na, C₁₂H₂₅OSO₃Na and C₁₂H₂₅PhC₆H₃(SO₃H)OPh(SO₃H) wherein R"" represents CⱼHₘ, CⱼFₘ or CⱼHₖFₗ, j is an integer from 0 to 30, m is an integer from 1 to 61, k is an integer from 1 to 60 and 1 is an integer from 1 to 60.

Among the above exemplified anionic surfactants, compounds represented by CₙHₘC₆H₃(SO₃H)Oph(SO₃H) where ph is a phenylene group, n is an integer from 1 to 30 and m is an integer from 3 to 61, compounds represented CₙHₘph(SO₃H) where ph, n and m are as above, and metal, ammonium, primary amine, secondary amine, and tertiary amine salts of these, etc., are preferably used.

In the above formula, the group expressed by CₙHₘ is such that n is an integer from 1 to 30 and m is an integer from 3 to 61. Specific examples thereof include aliphatic straight or branched alkyl groups, aliphatic alkenyl groups having 1 or more double bonds, alicyclic alkyl groups optionally having branches, alicyclic alkenyl groups optionally having branches and aromatic-substituted groups.

Preferable nonionic surfactants include polyethylene glycol-type surfactants wherein the hydrophilic group is expressed by the general formulae -R' (CH₂CH₂O)_{q}R'' or -R'O(CH₂CH₂O)_{q}R'' wherein R" is a hydrogen atom or alkyl group having 1-10 carbon atoms, R' is a hydrocarbon having 1-20 carbon atoms in which the hydrogen atoms are optionally substituted with one or more fluorine atom, and q is an integer from 0 to 30. Specific examples thereof include the following:
C₉F₁₇O(CH₂CH₂O)_{q}CH₃(q=0-30), C₉H₁₉Ph(CH₂CH₂O)₁₀H, C₁₂H₂₅O(CH₂CH₂O)_{q}H, C₉H₁₉PhO (CH₂CH₂O)₁₀H, C₉H₁₉PhO(CH₂CH₂O)₅H, C₈H₁₇PhO(CH₂CH₂O)₃H, and C₈H₁₇Ph(CH₂CH₂O)₁₀H wherein Ph is a phenylene group.

Examples of cationic surfactants include primary amines expressed by R"'NH₂; secondary amines expressed by R"'₂NH; tertiary amines expressed by R"'₃N and quaternary ammonium salts expressed by [R"'₄N]M' wherein R"' may be the same or different and independently represents a straight or branched alkyl group having 1-30 carbons optionally substituted with one or more fluorine atoms or OH group, a phenyl group that is optionally substituted with one or more fluorine atoms or OH groups, or hydrogen atom, and M' represents a monovalent anion (for example, Cl⁻). Specific examples of such compounds are as follows:
CH₃(CH₂)NH₂, (CH₃(CH₂)ₙ)₂NH, (CH₃(CH₂)ₙ)₃N, (CH₃(CH₂)ₙ)₄NCl, CH₃(CH₂)ₙN((CH₂)ₙOH)₂, CF₃(CF₂)ₙNH₂, (CF₃(CF₂)ₙ)₂NH, (CF₃(CF₂)ₙ)₃N, (CF₃(CF₂)ₙ)₄NCl, CF₃(CF₂)ₙN((CH₂)ₙOH)₂, C₆H₅NH₂, and (CH₃)₂(CH₂)ₙNH₂
wherein n is an integer from 1 to 30.

The content of surfactant is not limited as long as the desired effects of the invention can be achieved; however, it is generally about 0.0001-10 mass%, preferably about 0.001-5 mass% and particularly preferably about 0.01-1 mass%.

When the surfactant is anionic, the preferable amount is 0.001-10 mass%.

When the composition of the invention contains an anionic surfactant, it is preferable that the content of water be 60 mass% or less.

When the composition of the invention contains an anionic surfactant, it generally contains (1) at least one of fluorides and hydrogendifluorides in an amount of 0.001-10 mass%, (2) 20-99.988 mass% of heteroatom-containing organic solvent, (3) 0.01-60 mass% of water and (4) 0.001-10 mass% of anionic surfactant; and preferably (1) at least one of fluorides and hydrogendifluorides in an amount of 0.005-10 mass%, (2) 49.0-99.975 mass% of heteroatom-containing organic solvent, (3) 0.01-40 mass% of water and (4) 0.01-1 mass% of anionic surfactant.

More specifically, it is preferable that the composition for polymer removal comprise (1) a fluoride salt represented by NR₄F (wherein each R may be the same or different and independently represents a straight or branched alkyl group having 1-12 and preferably 1-4 carbon atoms optionally substituted with one or more fluorine atoms, and a phenyl group that is optionally substituted with one or more fluorine atoms, or hydrogen atom) in an concentration of 1 mass% or less and/or a hydrogendifluoride represented by NR₄HF₂ wherein R is as defined above in a concentration of 0.001-5 mass%, (3) 60 mass% or less of water, (4) 0.001-10 mass% of anionic surfactant, and (2) the balance be at least one member selected from the group consisting of isopropyl alcohol, ethanol and methanol.

The composition of the invention may further contain (5) an anticorrosive agent. Examples of anticorrosive agents include catechol, pyrogallol, oxine and like aromatic hydroxy compounds; benzotriazole, tolyltriazole and like triazole compounds and their derivatives; phthalic acid, salicylic acid, azelaic acid and like carboxyl-containing organic compounds, ethylenediaminetetraacetic acid and like aminopolycarboxylic acids, 1,2-propanaminetetramethylene phosphonic acid and like phosphonic acids; cupferron and like chelating agents; pyridine derivatives, sodium 2-mercaptobenzothiazole and like thiazole compounds; tetramethylammonium formates and like quaternary ammonium salts; sorbitol, arabitol, amylose and like saccharides and their derivatives. The amount of anticorrosive agent is not limited as long as the desired effects of the invention can be achieved; it is, however, generally about 0.01-30 mass% and preferably about 0.5-10 mass%.

The composition of the invention comprising (1) at least one member selected from fluorides and hydrogendifluorides; (2) heteroatom-containing organic solvent; and (3) water, has an etching rate relative to THOX and BPSG at 25 °C of 100 Å/min. or less, preferably 80 Å /min. or less, more preferably 60 Å/min. or less and most preferably 50 Å/min. or less.

The composition of the invention is of little corrosiveness to substrates of Al, Al-Cu, Cu, W, Ti, TiN, etc., and metals that are readily corroded, and can efficiently remove polymers attributable to resist and the like, native-oxide films, organic substances and other particles and like contaminants generated during fabricating a semiconductor, at low temperature and in a short time. The surface of the cleaned native-oxide film, etc., is not substantially changed from that before cleaning with no or almost no appearance of surface roughness.

Therefore, the composition of the invention can be used as a composition for cleaning metal gates, contact holes, via holes and capacitors during the process of fabricating a semiconductor, even when the gate electrode material contains metal. The cleaned substance is uncontaminated and has excellent adhesion to metal, etc.

In the invention, the objects to be cleaned are mid-process substrates in fabricating semiconductors, for example, substrate after forming contact holes but before embedding metals, etc.

More specifically, the cleaning composition of the invention can be used to clean a semiconductor substrate obtained in a semiconductor fabrication process by the steps of forming a resist pattern on a processed layer comprising an insulating layer film and conductive layer formed on the insulating layer film, the processed layer being formed on the silicon substrate that serves as a semiconductor substrate, and forming the processed layer into a predetermined pattern by dry etching using the resist as a mask. In this process, objects such as metal gates and metal wiring are formed on the semiconductor substrate.

The cleaning composition of the invention can also be used to clean a semiconductor substrate obtained in a semiconductor fabrication process by the steps of forming a conductive layer into a predetermined pattern on a silicon substrate, the silicon substrate serving as the semiconductor substrate, forming an insulating layer on the conductive layer, forming a resist pattern on a processed layer comprising the insulating layer, and forming the processed layer into a predetermined pattern by dry etching using the resist as a mask. In this process, objects such as contact holes are formed on the semiconductor substrate. This process corresponds to a dry etching process in the single or dual damascene processes.

Cleaning STIs, metal gates, contact holes, via holes and capacitors using the cleaning composition of the invention is performed by, for example, dipping the object to be cleaned (for example, a semiconductor substrate having at least one STI, metal gate, contact hole, via hole or capacitor) in the composition for about 0.5-30 minutes at about 15-40 °C, and preferably at about room temperature. Cleaning can be performed merely by contacting the cleaning composition with the object to be cleaned, and therefore it is also possible to clean by, for example, supplying a liquid to the object to be cleaned while rotating the object, spraying the cleaning composition onto the object, and/or dipping the object in the cleaning composition.

Semiconductor substrates cleaned using the composition of the invention can be fabricated into various kinds of semiconductor devices employing conventional methods (for example, methods described in Atlas of IC Technologies: An Introduction to VLSI Processes by W. Maly, 1987, The Benjamin/Cummings Publishing Company Inc.).

The composition of the invention is of low corrosiveness to substrates of Al, Al-Cu, Cu, W, Ti, TiN, etc., and metals that are readily corroded, and can efficiently remove polymers attributable to resist at low temperature and in a short time. Therefore, the cleaning composition of the invention aims at removing, during the process of fabricating semiconductor, resist polymer remaining on the side walls of STIs, metal gates, contact holes, via holes, capacitors, etc., after etching. In other words, the composition of the invention can be used as a composition for removing polymers.

The cleaning composition of the invention can also be used to remove polymers adhered in the process of forming STIs, metal gates, contact holes, via holes, capacitors and n⁺ or p⁺ regions, or after dry etching in the single or dual damascene processes.

Removal of polymer using the composition of the invention can be conducted by dipping the object to be cleaned (for example, a semiconductor substrate having at least one STI, metal gate, contact hole, via hole or capacitor) in the composition for about 0.5-30 minutes at about 15-40 °C and preferably at about room temperature. Also in this case, polymer removal can be performed merely by contacting the composition with the object to be cleaned, and therefore it is also possible to clean the object by, for example, supplying a liquid to the object to be cleaned while rotating the object and/or spraying the cleaning composition onto the object.

It is preferable that the composition of the invention be used to remove a polymer left on a semiconductor substrate having a fine pitch pattern (for example, a pattern having a pitch of about 0.0001-10 µm).

Semiconductor substrates from which polymer is removed by the composition of the invention can be fabricated into various kinds of semiconductor devices employing conventional methods (for example, methods described in Atlas of IC Technologies: An Introduction to VLSI Processes by W. Maly, 1987, The Benjamin/Cummings Publishing Company Inc.).

The cleaning composition of the invention (in particular, when it is used to remove a polymer) can be suitably used for cleaning a resist (including negative-and positive-type resists) that can be developed using an aqueous alkaline solution. Examples of such resists include (i) positive-type resists that contain a naphthoquinonediazide compound and a novolak resin; (ii) positive-type resists that contain a compound that generates acid by exposure, a compound that is decomposed by acid and increases its solubility to an alkaline solution, and an alkali-soluble resin; (iii) positive-type resists that contain a compound that generates acid by exposure, and an alkali-soluble resin containing a group that is decomposed by acid and increases its solubility to alkaline solution; and (iv) negative-type resists that contain a compound that generates an acid by exposure, a cross-linking agent, and an alkali-soluble resin; however the resist is not limited to these.

After etching, cleaning or removing using the composition of the invention may be conducted after ashing of the polymer attributable to remaining resist; however, it is also possible to clean or remove polymer without ashing.

The cleaning composition of the invention can also be used in liquid crystal panel manufacturing processes besides processes for fabricating semiconductors.

In the process of fabricating a semiconductor, a cleaning step is necessary to remove polishing agents from the surface after CMP in the single damascene or dual damascene process. When the cleaning composition of the invention is used, it is possible to remove a polishing agent remaining on the surface after CMP by brush, etc. Therefore, the cleaning composition of the invention can also be used as a composition for cleaning the surface after CMP during the process of fabricating a semiconductor.

Post-CMP cleaning using the composition of the invention can be conducted by, for example, dipping the object to be cleaned in the composition for about 0.1-30 minutes at about 15-40 °C and preferably at about room temperature, or pouring the composition on the object for about 1 second to 10 minutes at about 15-40 °C and preferably at about room temperature. During the cleaning step, brushing may or may not be used; however, using a brush improves the efficiency of eliminating slurry and is thus preferable. It is also possible to conduct post-CMP cleaning by dipping the object to be cleaned in the composition of the invention and performing ultrasonic cleaning (megasonic).

The above-described cleaning step can be carried out after subjecting to CMP a processed layer in which a conductive layer and an insulating layer coexist on the same surface of a semiconductor substrate or a processed layer composed of a conductive layer, for example, after conducting CMP in a single or dual damascene process in which a plug or wiring is formed.

The damascene process is also employed in, for example, liquid crystal panel manufacturing. The composition of the invention can be used in the post-CMP cleaning process in the single damascene or dual damascene processes.

The invention includes a method for fabricating a semiconductor device comprising a step of forming a processed layer containing both a conductive layer and an insulating layer on one surface of a semiconductor substrate by a single damascene or dual damascene process, and a step of cleaning the processed layer using the cleaning composition of the invention.

Semiconductor substrates cleaned by the composition of the invention can be fabricated into various kinds of semiconductor devices employing conventional methods (for example, methods described in Atlas of IC Technologies: An Introduction to VLSI Processes by W. Maly, 1987, The Benjamin/Cummings Publishing Company Inc.).

### BEST MODE FOR CARRYING OUT THE INVENTION

The present invention is explained in detail below with reference to Examples; however, the scope of the invention is not limited to these Examples.

In the Examples below, etching rates of oxide films were obtained by measuring the thickness of the film before and after etching using a Rudolf Research Auto EL III ellipsometer. The etching rates of metals were obtained by measuring the resistivity before and after etching using a resistivity processor K-705RS, product of Kyowa Riken Inc.) and the thickness was determined from the resistivity.

The etching rates of the compositions below were obtained, after etching each film using the composition at 23 °C, by dividing the difference in thickness of the film before and after etching by the etching time.

Surface roughness of the oxide films was observed from images taken using a scanning electron microscope (S-5000, product of Hitachi, Ltd.).

### Test Example 1: Measuring etching rate and surface roughness of oxide film

A fluoride or hydrogendifluoride, water and a heteroatom-containing organic solvent at a constituent ratio shown in Examples 1-15 and Comparative Examples 1-9 were mixed, and the etching rates of the mixtures relative to test substrates in which one of THOX (thermal oxide film), BPSG film and PE-TEOS film is formed on a silicon substrate, and surface roughness of the test substrates after etching were measured. The surface roughness of the THOX, BPSG and PE-TEOS substrates were categorizeded in three categories: "A" (no roughness found), "B" (little roughness found) and "C" (roughness found). The results are shown in Table 1.

### Examples 1-15 and Comparative Examples 1-9

Compounds having the ratio of chemical constituents shown below were prepared by a standard method.
Example 1: C₂H₅NH₃·HF₂ (0.85 wt%), water (0.59 wt%), reminder IPA
Example 2: C₂H₅NH₃·HF₂ (0.85 wt%), water (0.59 wt%), remainder methanol
Example 3: C₂H₅NH₃·HF₂ (0.85 wt%), water (0.59 wt%), remainder ethanol
Example 4: C₂H₅NH₃·HF₂ (0.85 wt%), water (0.59 wt%), remainder acetone
Example 5: C₂H₅NH₃·HF₂ (0.85 wt%), water (0.59 wt%), remainder acetic acid
Example 6: C₂H₅NH₃·F (1.95 wt%), water (1.12 wt%), remainder IPA
Example 7: C₂H₅NH₃·HF₂ (0.425 wt%), water (0.30 wt%), remainder IPA
Example 8: HOC₂H₄NH₃·HF₂ (1.01 wt%), water (0.4 wt%), remainder IPA
Example 9: (CH₃)₂NH₂·HF₂ (0.43 wt%), water (0.43 wt%), remainder IPA
Example 10: (CH₃)₂NH₂·HF₂ (0.99 wt%), water (1.24 wt%), remainder IPA
Example 11: C₅H₁₁NH₃·HF₂ (1.25 wt%), water (0.40 wt%), remainder IPA
Example 12: C₈H₁₇NH₃·HF₂ (2.68 wt%), water (0.4 wt%), remainder IPA
Example 13: C₁₀H₂₁NH₃·HF₂ (1.97 wt%), water (0.4 wt%), remainder IPA
Example 14: (C₂H₅)₄N·HF₂ (1.69 wt%), water (3.14 wt%), remainder IPA
Example 15: (C₆H₅)CH₂NH₃·HF₂ (0.74 wt%), water (0.2 wt%), remainder IPA
Comparative Example 1: NH₄·HF₂ (0.01 wt%), water (0.3 wt%), remainder IPA
Comparative Example 2: NH₄·HF₂ (0.08 wt%), water (0.3 wt%), remainder IPA
Comparative Example 3: NH₄·HF₂ (1.7 wt%), water (1.5 wt%), remainder methanol
Comparative Example 4: NH₄·HF₂ (2.28 wt%), water (1.5 wt%), remainder ethanol
Comparative Example 5: NH₄·HF₂ (2.28 wt%), water (1.5 wt%), remainder acetone
Comparative Example 6: NH₄F (0.12 wt%), remainder acetic acid
Comparative Example 7: CH₃NH₃·HF₂ (0.21 wt%), water (0.26 wt%), remainder IPA
Comparative Example 8: HONH₃·HF₂ (0.73 wt%), water (1.13 wt%), remainder IPA
Comparative Example 9: (CH₃)₄N·HF₂ (1.13 wt%), water (2.99 wt%), remainder IPA

**Table 1**

| | Etching rate (Å/min.) | | | Surface roughness | | |
|---|---|---|---|---|---|---|
| Composition | THOX | BPSG | PE-TEOS | THOX | BPSG | PE-TEOS |
| Example 1 | 17 | 17 | 37 | A | A | A |
| Example 2 | 9 | 13 | 31 | A | A | A |
| Example 3 | 17 | 12 | 58 | A | A | A |
| Example 4 | 14 | 13 | 44 | A | A | A |
| Example 5 | 61 | 120 | 130 | A | A | A |
| Example 6 | 2 | 4 | 4 | A | A | A |
| Example 7 | 11 | 12 | 39 | A | A | A |
| Example 8 | 10 | 11 | 21 | A | A | A |
| Example 9 | 16 | 15 | 33 | A | A | A |
| Example 10 | 19 | 20 | 55 | A | A | A |
| Example 11 | 11 | 12 | 16 | A | A | A |
| Example 12 | 9 | 7 | 10 | A | A | A |
| Example 13 | 8 | 7 | 9 | A | A | A |
| Example 14 | 1 | 4 | 6 | A | A | A |
| Example 15 | 11 | 10 | 27 | A | A | A |
| Comp.Ex. 1 | 11 | 10 | 14 | C | C | C |
| Comp.Ex. 2 | 43 | 36 | 48 | C | C | C |
| Comp.Ex. 3 | 31 | 58 | 92 | B | C | C |
| Comp.Ex. 4 | 28 | 34 | 46 | C | C | C |
| Comp.Ex. 5 | 16 | 18 | 22 | C | C | C |
| Comp.Ex. 6 | 9 | 12 | 30 | A | C | C |
| Comp.Ex. 7 | 14 | 13 | 25 | B | B | C |
| Comp.Ex. 8 | 27 | 41 | 50 | C | B | C |
| Comp.Ex. 9 | 2 | 7 | 11 | A | B | B |

### Test Example 2: Measurement of metal etching rate

A fluoride or hydrogendifluoride, water and a heteroatom-containing organic solvent were mixed at the ratios shown in Examples 3, 6, 7, 8 and 12, and Comparative Examples 1 and 10-12, giving etching solutions.

Using these etching solutions, test substrates of Al-Cu, Cu, W, WN, Ti and TiN wafers were etched at 23 °C, and the etching rates relative to each film were obtained. Table 2 shows the results.

### Comparative Examples 10-12

Compositions having the ratio of chemical constituents shown below were prepared by a standard method.
Comparative Example 10: 0.29 % aqueous ammonia
Comparative Example 11: 0.25 wt% hydrofluoric acid
Comparative Example 12: HF (0.125 wt%), NH₄F (40 wt%), remainder water

**Table 2**

| | Etching rate of metal at 23 °C (Å/min.) | | | | | |
|---|---|---|---|---|---|---|
| Composition | Al-Cu | Cu | W | WN | Ti | TiN |
| Example 3 | 140 | 1.5 | 0.1 | 0.2 | 0.1 | 0.1 or less |
| Example 6 | 43 | 1.4 | 0.1 or less | 0.1 or less | 0.1 or less | 0.1 or less |
| Example 7 | 15 | 0.8 | 0.1 | 0.1 or less | 0.1 | 0.1 or less |
| Example 8 | 14 | 2 | 0.1 | 0.1 or less | 0.1 or less | 0.1 or less |
| Example 12 | 22 | 1.2 | 0.1 | 0.9 | 0.1 | 0.1 or less |
| Comparative Example 1 | 1.5 | 0.2 | 0.1 | 0.8 | 0.1 | 0.1 or less |
| Comparative Example 10 | 50 | 97 | 1.5 | 2.1 | 0.9 | 0.2 |
| Comparative Example 11 | 670 | 10 | 0.9 | 1.5 | 1.6 | 0.2 |
| Comparative Example 12 | 210 | 10 | 0.3 | 1.4 | 0.9 | 0.1 or less |

### Test Example 3

In the composition of Example 7 (C₂H₅NH₃·HF₂ (0.425 wt%), water (0.3 wt%), remainder IPA), the concentration of C₂H₅NH₃·HF₂ was fixed at 0.425 wt% and the ratio of water and IPA was changed as shown in Table 3 (only the amount of water is shown with the balance being IPA), and Al-Cu, Cu, W, WN, Ti and TN were etched under the same conditions as in Test Example 2, and etching rates were thereby obtained. Table 3 shows the results.

**Table 3**

| Concentration of water (wt%) | Al-Cu | Cu | W | WN | Ti | TiN |
|---|---|---|---|---|---|---|
| 0.3 | 15 | 0.8 | 0.1 | 0.1 or less | 0.1 | 0.1 or less |
| 5 | 64 | 2.2 | 0.1 | 0.1 or less | 0.1 | 0.1 or less |
| 10 | 86 | 2.5 | 0.1 | 0.1 or less | 0.1 | 0.1 or less |
| 20 | 89 | 2.6 | 0.1 | 0.1 or less | 0.1 | 0.1 or less |
| 40 | 117 | 12 | 0.1 | 0.1 or less | 0.4 | 0.1 or less |
| 60 | 151 | 14 | 0.2 | 0.1 or less | 0.9 | 0.1 or less |
| 100 | 409 | 20 | 0.3 | 0.1 or less | 1.5 | 0.1 or less |

### Test Example 4: Polymer cleaning test

A resist pattern formed of naphthoquinone/novolak resin-based positive photo resist was formed by the conventional method on a silicon wafer comprising an interlayer insulating film on its surface and a Cu wiring layer disposed below the interlayer insulating film. The silicon wafer having the thus obtained resist pattern was subjected to oxide film dry etching by the usual method, forming via hole. The silicon wafer was then subjected to ashing using oxygen gas, removing the residual resist.

Silicon wafers having thus obtained via holes were dipped in one of the composition of Examples 3, 6, 7, 8 and 12, and Comparative Examples 1 and 10-12 at 23°C for 10 minutes to remove the deposited polymer. The treated wafers were then rinsed with pure water, and evaluation of the extent of removal of ashed residue (deposited polymer) on the silicon wafer and existence of corrosion of wiring metal was conducted by observing images taken by a SEM (scanning electron microscope). The removal extent of the deposited polymer was categorized by a two-modal assessment, i.e., "complete" or "incomplete"; existence of wiring metal corrosion was similarly evaluated, i.e. "present" or "not present", and roughness of the oxide film was categorized by a three-modal assessment, i.e. "A" (no roughness found), "B" (little roughness found) and "C" (roughness found). Table 4 shows the results.

**Table 4**

| Composition | Removal extent of the deposited polymer | Corrosion of wiring metal | Roughness of oxide film |
|---|---|---|---|
| Example 3 | Complete | Not present | A |
| Example 6 | Complete | Not present | A |
| Example 7 | Complete | Not present | A |
| Example 8 | Complete | Not present | A |
| Example 12 | Complete | Not present | A |
| Comp.Ex. 1 | Complete | Not present | C |
| Comp.Ex. 10 | Complete | Present | A |
| Comp.Ex. 11 | Complete | Present | A |
| Comp.Ex. 12 | Complete | Present | A |

From the results of Test Examples 1-4, it became clear that the composition of the invention has the ability to remove polymer (resist) and does not corrode wiring metal. Therefore, the composition of the invention is suitable as a composition for cleaning STIs, metal gates, contact holes, via holes, capacitors, etc. Furthermore, it became clear that the cleaning composition of the invention can be suitably used to remove residual polymer on the side walls of STIs, metal gates, contact holes, via holes, capacitors, etc.

## Claims

1. A cleaning composition comprising (1) at least one fluoride and/or hydrogendifluoride salt formed from at least one member selected from the group consisting of hydroxylamines, aliphatic amines, aromatic amines, aliphatic quaternary ammonium salts and aromatic quaternary ammonium salts with hydrofluoric acid; (2) at least one organic solvent that includes one or more heteroatoms; and (3) water.

2. A cleaning composition according to Claim 1, wherein the fluoride is expressed by the general formula below:
N(R¹) (R²)₃ · F
wherein R¹ represents a straight or branched C₁₋₁₂ alkyl group that is optionally substituted with one or more fluorine atoms and/or hydroxyl groups, a phenyl group that is optionally substituted with one or more fluorine atoms, or a hydroxyl group, and each R² may be the same or different and independently represents a straight or branched C₁₋₁₂ alkyl group that is optionally substituted with one or more fluorine atoms and/or hydroxyl groups, a phenyl group that is optionally substituted with one or more fluorine atoms, or a hydrogen atom; and the hydrogendifluoride is expressed by the general formula below:
N(R¹) (R²)₃ · HF₂
wherein R¹ and R² are as defined above.

3. A cleaning composition according to Claim 1, wherein the hydroxylamines are at least one member selected from hydroxylamines mono- or di-substituted with a phenyl group or a straight or branched alkyl group having 1-4 carbon atoms, such as N,N-dimethylhydroxylamine, *N*-ethylhydroxylamine, *N*,*N*-diethylhydroxylamine, *N*-propylhydroxylamine, *N*-phenylhydroxylamine and the like.

4. A cleaning composition according to Claim 1, wherein the aliphatic amines include aliphatic amines mono-, di- or tri-substituted with a straight or branched alkyl group having 1 to 12 carbon atoms such as ethylamine, propylamine, isopropylamine, butylamine, hexylamine, octylamine, decylamine, dodecylamine, dimethylamine, diethylamine, dipropylamine, diisopropylamine, dibutylamine, trimethylamine, triethylamine, tripropylamine, triisopropylamine, tributylamine and the like ; aliphatic amines mono-, di- or tri-substituted with a straight or branched C₁-C₈ alkyl group having at least one fluorine atom such as fluoromethylamine, difluoromethylamine, trifluoromethylamine, perfluoroethylamine, perfluoropropylamine, perfluoroisopropylamine, perfluorobutylamine, perfluorohexylamine, perfluorooctylamine, di(perfluoromethyl)amine, di(perfluoroethyl)amine, di(perfluoropropyl)amine, di(perfluoroisopropyl)amine, di(perfluorobutyl)amine, tri(perfluoromethyl)amine, tri(perfluoroethyl)amine, tri(perfluoropropyl)amine, tri(perfluoroisopropyl)amine, tri(perfluorobutyl)amine and the like ; ethanolamine, ethylenediamine, 2-(2-aminoethylamino)ethanol, diethanolamine, 2-ethylaminoethanol, dimethylaminoethanol, ethyldiethanolamine, cyclohexylamine and dicyclohexylamine.

5. A cleaning composition according to Claim 1, wherein the aliphatic or aromatic quaternary ammonium salt is at least one member selected from the group consisting of chlorides, bromides, sulfates, nitrates and like mineral acid salts of tetraethylammonium, tetrapropylammonium, tetraisopropylammonium, tetrabutylammonium, tetraphenylammonium and like aliphatic or aromatic quaternary ammoniums.

6. A cleaning composition according to Claim 1, wherein the organic solvent including one or more heteroatoms is at least one member selected from the group consisting of *N*,*N*-dimethylformamide, *N*,*N*-dimethylacetamide, dimethysulfoxide, *N*-methyl-2-pyrrolidone, 1,3-dimethyl-2-imidazolidinone; methanol, ethanol, isopropyl alcohol (IPA), 1-propanol, 1-butanol, 2-butanol, *t*-butanol, 2-methyl-1-propanol, 1-pentanol, 1-hexanol, 1-heptanol, 4-heptanol, 1-octanol, 1-nonyl alcohol, 1-decanol, 1-dodecanol and like alcohols; ethylene glycol, 1,2-propanediol, propylene glycol, 2,3-butanediol, glycerol and like polyols; acetone, acetylacetone, methyl ethyl ketone and like ketones; acetonitrile, propionitrile, butyronitrile, isobutyronitrile, benzonitrile and like nitriles; formaldehyde, acetaldehyde, propionaldehyde and like aldehydes; ethylene glycol monomethyl ether, ethylene glycol monoethyl ether, diethylene glycol monobutyl ether and like alkylene glycol monoalkyl ethers; tetrahydrofuran, dioxane and like cyclic ethers; trifluoroethanol, pentafluoropropanol, 2,2,3,3-tetrafluoropropanol and like fluorinated alcohols; sulfolane and nitromethane.

7. A cleaning composition according to Claim 6, wherein the organic solvent including one or more heteroatoms is an oxygen-containing organic solvent that is at least one member selected from the group consisting of alcohols and ketones.

8. A cleaning composition according to Claim 7, wherein the oxygen-containing organic solvent is at least one member selected from the group consisting of isopropyl alcohol, ethanol and methanol.

9. A cleaning composition according to Claim 7, wherein the oxygen-containing organic solvent is at least one member selected from the group consisting of isopropyl alcohol, ethanol and methanol, and the concentration of water is 10 mass% or less.

10. A cleaning composition according to Claim 2, wherein (1) the concentration of the fluoride expressed by general formula below is 10 mass% or less:
N(R¹) (R²)₃ · F
wherein R¹ represents a straight or branched C₁₋₁₂ alkyl group that is optionally substituted with one or more fluorine atoms and/or hydroxyl groups, a phenyl group that is optionally substituted with one or more fluorine, or a hydroxyl group, and each R² may be the same or different and independently represents a straight or branched C₁₋₁₂ alkyl group that is optionally substituted with one or more fluorine atoms and/or hydroxyl groups, a phenyl group that is optionally substituted with one or more fluorine atoms, or a hydrogen atom; and/or the concentration of the hydrogendifluoride represented by the general formula below:
N(R¹) (R²)₃ · HF₂
(wherein R¹ and R² are as defined above) is 0.001-10 mass%; (3) the concentration of water is 10 mass% or less; and (2) the balance is at least one member selected from the group consisting of isopropyl alcohol, ethanol and methanol.

11. A method for removing a deposited substance from an object to be cleaned that has at least one STI, metal gate, contact hole, via hole or capacitor, comprising the step of cleaning the object to be cleaned using the composition of Claim 1.

12. A method according to Claim 11, wherein the deposited substance is a resist remaining on an etched surface or a resist polymer remaining on at least one side wall of an STI, metal gate, contact hole, via hole and capacitor.

13. A method according to Claim 11, wherein the deposited substance is a residual polishing agent after CMP in a single damascene or dual damascene process.

14. A method according to Claim 11, wherein the deposited substance is a resist residue after ion implantation.

15. A method according to Claim 11, wherein the deposited substance is a resist remaining after etching and the method comprises a step of ashing the resist before cleaning the object to be cleaned.

16. A method according to Claim 11, wherein cleaning is performed by at least one of the steps of dipping the object to be cleaned in the composition of Claim 1, continuously or intermittently supplying the composition of Claim 1 to the object to be cleaned, and spraying the composition of Claim 1 onto the object to be cleaned.
